# FASCICULE DE BREVET EUROPEEN

(11) **EP 4 107 306 B1**
(45) Date de publication et mention de la délivrance du brevet: **29.11.2023**
(21) Numéro de dépôt: 21709076.0
(22) Date de dépôt: 10.02.2021
(51) Int. Cl.: C04B 35/571, C23C 16/02, C23C 16/04, C23C 16/32, C23C 16/455, C23C 16/458, C04B 35/80, C04B 35/628, C04B 35/565

(54) **PROCÉDÉ DE CONSOLIDATION PAR INFILTRATION EN PHASE GAZEUSE**
VERFESTIGUNGSVERFAHREN MITTELS GASPHASENINFILTRATION
CONSOLIDATION METHOD USING GAS PHASE INFILTRATION

(30) Priorité: 19.02.2020 FR 2001672
(43) Date de publication de la demande: 28.12.2022
(73) Titulaire: Safran Ceramics, 33185 Le Haillan (FR)
(72) Inventeur: GOUJARD, Stéphane, Roger, André, 77550 Moissy-Cramayel (FR); DELCAMP, Adrien, 77550 Moissy-Cramayel (FR); DESCAMPS, Cédric, 77550 Moissy-Cramayel (FR); TESSON, Thierry, Guy, Xavier, 77550 Moissy-Cramayel (FR); LELEU, Charles, 77550 Moissy-Cramayel (FR)
(74) Mandataire: Cabinet Beau de Loménie
(86) Numéro de dépôt international: PCT/FR2021/050243
(87) Numéro de publication internationale: WO 2021/165599

(56) Documents cités:
- EP-A2- 1 452 624
- JP-A- H05 161 957
- KR-B1- 101 934 374

## Description

### Domaine Technique

La présente invention concerne la réalisation de pièces en matériau composite, et plus particulièrement, un procédé de consolidation et/ou de densification par infiltration chimique en phase gazeuse d'une préforme destinée à former un renfort de pièce en matériau composite.

### Technique antérieure

Un domaine d'application de l'invention est celui de la réalisation de pièces en matériau composite thermostructural, c'est-à-dire en matériau composite ayant à la fois des propriétés mécaniques qui le rendent apte à constituer des pièces structurelles et la capacité de conserver ces propriétés jusqu'à des températures élevées. Des exemples typiques de matériaux composites thermostructuraux sont les composites carbone/carbone (C/C) ayant une texture de renfort en fibres de carbone densifiée par une matrice de carbone pyrolytique et les composites à matrice céramique (CMC) ayant une texture de renfort en fibres réfractaires (carbone ou céramique) densifiée par une matrice céramique.

Un processus bien connu de consolidation ou de densification de préformes fibreuses pour réaliser des pièces en composite C/C ou en CMC est l'infiltration chimique en phase gazeuse (CVI). Par exemple, le document EP 1452624 décrit un procédé d'infiltration chimique en phase gazeuse. Les préformes fibreuses à consolider ou à densifier sont placées dans un outillage de conformation multiperforé lui-même placé dans un réacteur ou four où il est chauffé. Un gaz réactif contenant un ou plusieurs précurseurs gazeux du matériau constitutif de la matrice est introduit dans le réacteur. La température et la pression dans le réacteur sont réglées pour permettre au gaz réactif de diffuser au sein de la porosité des préformes via les perforations du conformateur et d'y former un dépôt du matériau constitutif de la matrice par décomposition d'un ou plusieurs constituants du gaz réactif ou par réaction entre plusieurs constituants, ces constituants formant le précurseur de la matrice. Un matériau d'interphase peut être en outre déposé avec la matrice par ce procédé.

Cependant, cette technique de consolidation ou de densification entraîne dans certains cas l'apparition de gradients de dépôt de matrice dans le sens de l'épaisseur de la préforme fibreuse ainsi que de surépaisseurs locales ou « pustules » à la surface de la préforme. En effet, à l'endroit des perforations d'un conformateur selon l'art antérieur, la texture n'est pas maintenue et à tendance à s'étendre dans l'espace libre. L'état de surface de la pièce s'en trouve défavorablement affecté.

De plus, les conformateurs sont généralement introduits dans une chambre de réaction d'un four de densification bien plus grande que les conformateurs eux-mêmes, si bien qu'une partie de la phase gazeuse introduite peut traverser la chambre du four de densification sans passer par les conformateurs, et ne contribue donc pas à la densification des préformes. Il en résulte une perte économique pour l'utilisateur, un tel procédé nécessitant un apport plus important en phase réactive.

De plus, les chambres des fours de densification et les faces externes des conformateurs subissent également des dépôts non souhaités lorsque la phase gazeuse réactive réagit avant d'entrer en contact avec la préforme présente dans les conformateurs. Ces dépôts occasionnent à terme un encrassement et donc un vieillissement prématuré non désiré du four de densification et des conformateurs conduisant à introduire des opérations de nettoyage ou réduisant leur durée possible d'utilisation.

Il demeure un besoin industriel pour un procédé de conformation par infiltration chimique en phase vapeur qui permette la conformation d'une préforme et qui ne soit pas associée aux désavantages décrits ci-dessus.

### Exposé de l'invention

L'invention répond à ce besoin en proposant un procédé de consolidation comprenant les étapes consistant en :
- placer une préforme fibreuse dans le logement de conformation d'un outillage de conformation ;
- alimenter l'outillage de conformation en une phase gazeuse pour obtenir un dépôt dans la préforme fibreuse,

l'outillage de conformation pour l'infiltration chimique en phase vapeur d'une préforme fibreuse, comprenant une première partie dont une face présente une première zone de conformation entourée d'une première zone de bord, et une deuxième partie, dont une face présente une deuxième zone de conformation entourée d'une deuxième zone de bord, la première et la deuxième zone de conformation définissant, lors de la mise en contact de la première zone de bord avec la deuxième zone de bord, un logement de conformation de forme déterminée destiné à accueillir la préforme fibreuse, caractérisé en ce qu'au moins un orifice d'injection de gaz est présent au moins partiellement dans la première ou dans la deuxième zone de bord et un orifice de sortie gaz est présent au moins partiellement dans la première ou dans la deuxième zone, l'orifice d'injection de gaz et l'orifice de sortie de gaz mettant le logement de conformation en communication fluidique avec l'extérieur de l'outillage de conformation,
et en ce que les faces externes de la première et de la deuxième partie sont imperméables aux gaz.

Un tel procédé utilise avantageusement un outillage permettant de forcer le passage de la phase gazeuse au sein de la préforme présente dans le logement de conformation. Dans un tel outillage de conformation, la phase gazeuse peut être introduite directement dans le logement de conformation via l'orifice d'injection de gaz, et les espèces réactives de la phase gazeuse génèrent plus facilement un dépôt dans la préforme ainsi que cela est souhaité. Le rendement de dépôt s'en trouve ainsi augmenté comparativement à des conformateurs de l'art antérieur. De plus, le vieillissement du conformateur dû au dépôt non souhaité d'espèces issues de la phase gazeuse réactive, telles que SiC ou BN par exemple, s'en trouve diminué car seules les faces des zones de conformation des conformateurs d'un procédé selon l'invention sont en contact avec la phase gazeuse réactive et peuvent ainsi faire l'objet d'un dépôt solide non souhaité. De plus, il est plus aisé de rénover un conformateur d'un procédé selon l'invention car cela nécessite seulement de réusiner les zones de conformation et non l'ensemble du conformateur comme avec les conformateurs de l'art antérieur. Enfin, l'alimentation de la phase gazeuse réactive est directement faite dans le logement de conformation et donc au plus près de la préforme. La cinétique de dépôt s'en trouve augmentée comparativement à des conformateurs de l'art antérieur à parois multi-perforées placées dans un four de densification.

Dans l'outillage pour un procédé selon l'invention, les zones de conformation de la première partie et de la deuxième partie peuvent être mises en forme de sorte que le logement de conformation ait la forme de la pièce souhaitée après conformation.

Les zones de bords peuvent s'entendre comme la zone de la première ou de la deuxième partie du conformateur qui entoure la zone de conformation.

Dans l'outillage pour un procédé selon l'invention, le logement de conformation est obtenu par la réunion de la première et de la deuxième partie par mise en contact d'au moins une partie de la première zone de bord avec la deuxième zone de bord.

Dans un mode de réalisation de l'invention, l'outillage de conformation comprend au moins une première partie d'un orifice d'injection de gaz ménagé dans la première zone de bord, et une deuxième partie d'un orifice d'injection de gaz dans la deuxième zone de bord. Ainsi, lors de la mise en contact des zones de bord de la première et de la deuxième partie d'un outillage pour un procédé selon l'invention, les première et deuxième parties d'un orifice d'injection forment ensemble un orifice d'injection de gaz permettant de mettre le logement de conformation en communication fluidique avec l'extérieur de l'outillage.

Dans un mode de réalisation de l'invention, l'outillage de conformation comprend au moins une première partie d'un orifice de sortie de gaz ménagé dans la première zone de bord, et une deuxième partie d'un orifice de sortie de gaz dans la deuxième zone de bord. Ainsi, lors de la mise en contact des zones de bord de la première et de la deuxième partie d'un outillage pour un procédé selon l'invention, les première et deuxième parties d'un orifice de sortie de gaz forment ensemble un orifice de sortie de gaz permettant de mettre le logement de conformation en communication fluidique avec l'extérieur de l'outillage.

Un outillage pour un procédé selon l'invention peut posséder plus d'un orifice d'injection de gaz.

Un outillage pour un procédé selon l'invention peut posséder plus d'un orifice de sortie de gaz.

Par « mise en communication fluidique », on entend au sens de l'invention qu'une phase gazeuse, éventuellement sous pression, peut parvenir de l'extérieur de l'outillage jusqu'au logement de conformation définit par les zones de conformation de l'outillage.

On ne sort pas non plus du cadre de l'invention lorsque les première et deuxième zones de bords ne sont pas en contact direct pour former le logement de conformation.

Dans un mode de réalisation, un outillage de conformation peut comprendre un joint d'étanchéité entre les première et deuxième zones de bord.

Un tel joint permet avantageusement d'assurer que le logement de conformation ne soit en communication fluidique avec l'extérieur de l'outillage qu'au travers des orifices d'injection et de sortie de gaz. Par exemple un tel joint d'étanchéité peut être composé d'un matériau réfractaire compressible comme du graphite expansé, par exemple vendu sous les dénominations commerciales Payex ^{®} ou Sigraflex ^{®}.

Un tel joint d'étanchéité permet d'assurer que la phase gazeuse passe par l'intégralité de la préforme contenue dans le logement de conformation. Dans ce mode de réalisation, le rendement de dépôt de la phase gazeuse dans la préforme fibreuse est augmenté comparativement à un conformateur de l'art antérieur.

Dans un mode de réalisation, les première et deuxième parties de l'outillage disposent en outre de moyens de fixation aptes à les maintenir ensemble.

Par exemple, de tels moyens de fixations peuvent être des organes de serrages de types vis et écrous disposés dans des logements prévus à cet effet dans les première et deuxième zones de bord.

Dans un mode de réalisation, au moins l'une des zones de conformation comprend un ou plusieurs relief(s) de circulation de la phase gazeuse. De tels reliefs de circulation peuvent être, par exemple, des rainures gravées dans les zones de conformation.

Les reliefs de circulation de la phase gazeuse permettent avantageusement au gaz de pénétrer dans la préforme fibreuse présente dans le logement de conformation sur toute la surface de la préforme en regard des reliefs de circulation. De tels reliefs de circulation sont particulièrement préférés dans le cas où la phase gazeuse comprend un précurseur sensible à des phénomènes d'appauvrissement et/ou d'inhibition des réactions de dépôt par les produits de réaction. Les reliefs de circulation permettent aussi d'ajuster la différence de pression entre le gaz entrant dans l'outillage et le gaz sortant de l'outillage de conformation. Les reliefs de circulation permettent alors d'obtenir un dépôt plus homogène.

De telles phases gazeuses sensibles à des phénomènes d'appauvrissement et/ou d'inhibition peuvent par exemple être composées de méthyltrichlorosilane (MTS) et d'hydrogène pour donner un dépôt de carbure de silicium. Il est connu de l'homme de l'art que le dépôt de SiC produit du chlorure d'hydrogène HCl. Or, une augmentation de la concentration d'HCl dans la phase gazeuse induit une décroissance de la cinétique de dépôt. En effet, l'HCl vient occuper des sites à la surface du substrat qui contrarient l'adsorption des molécules responsables des dépôts de SiC.

Dans un mode de réalisation alternatif, les zones de conformations de la première et de la deuxième partie forment un logement de conformation aux dimensions conformes à celles de la pièce que l'on souhaite obtenir. En d'autres termes, les zones de conformation sont dépourvues de reliefs de circulation de la phase gazeuse tels que ceux décrits ci-dessus. Un tel mode de réalisation est préféré lorsque la phase gazeuse est moins sensible à des phénomènes d'appauvrissement et/ou d'inhibition. Il est en effet alors préféré que la phase gazeuse traverse l'intégralité de la préforme fibreuse.

Dans un mode de réalisation, la préforme fibreuse est une préforme en fibres de carbure de silicium. Dans un autre mode de réalisation, la préforme est en fibres de carbone ou en fibres de bore. Des fibres oxyde peuvent également être utilisées.

Dans un mode de réalisation, la phase gazeuse réactive peut être choisie pour effectuer des dépôts de pyrocarbone à partir d'un mélange de méthane et de propane, de nitrure de bore, à partir d'un mélange de trichlorure de bore, d'ammoniac et d'hydrogène, de carbure de silicium à partir de MTS et d'hydrogène.

Selon l'invention, les faces externes de la première et de la deuxième partie sont imperméables aux gaz.

Par « face externe » de la première ou de la deuxième partie il est entendu la face de la première ou de la deuxième partie opposée à la face portant la zone de conformation.

Par « imperméable aux gaz », il est entendu qu'une phase gazeuse, même sous pression, ne peut pas traverser la face externe pour parvenir jusqu'au logement de conformation.

Par exemple, les faces externes de la première et de la deuxième face sont dénuées de tout interstice qui permettrait le passage d'un gaz depuis l'extérieur de l'outillage jusqu'au logement de conformation autrement que via l'orifice d'injection de gaz, ou l'orifice de sortie de gaz.

Un tel mode de réalisation permet d'éviter la formation de pustules observée dans les conformateurs aux parois multi-perforées de l'art antérieur.

Selon un autre de ses aspects, l'invention concerne également une installation de densification de préformes fibreuses pour la mise en oeuvre du procédé décrit ci-dessus, comprenant un outillage de conformation tel que celui décrit ci-dessus, un moyen de chauffage de l'outillage de conformation et une source de phase gazeuse connectée à l'orifice d'injection du gaz de l'outillage de conformation.

Une telle installation permet d'injecter directement dans le logement de conformation de l'outillage de conformation la phase gazeuse et ainsi d'obtenir un dépôt de meilleur rendement qu'avec les installations de l'art antérieur.

Dans un mode de réalisation, l'installation de densification comprend en outre une zone de réaction des effluents connectée à l'orifice de sortie des gaz de l'outillage de conformation. Généralement, cette zone est placée à une température au moins égale à la température de la zone comprenant le conformateur pour continuer la réaction de dépôt au-delà de la pièce à consolider.

Une telle zone permet de faire réagir les gaz de la phase gazeuse n'ayant pas réagi dans l'outillage de conformation afin de faciliter le traitement des effluents en sortie d'installation. Par exemple, une telle zone peut contribuer à limiter la formation d'espèces indésirables en d'autres endroits de l'installation, et notamment des dépôts qui encrassent les tuyauteries d'évacuation des gaz de l'installation. Cela permet de réduire les phases de nettoyage des canalisations, d'obtenir un meilleur contrôle de la pression dans l'ensemble de l'installation de densification en supprimant les risques de formation de bouchons.

Dans un mode de réalisation, l'installation comprend en outre une zone intermédiaire entre la source en phase gazeuse et l'outillage de conformation. Une telle zone intermédiaire permet le préchauffage de la phase gazeuse et/ou la maturation de la phase gazeuse, c'est-à-dire permet l'activation des réactifs contenus dans la phase gazeuse et ainsi un meilleur rendement de dépôt ou l'obtention d'une composition de dépôt adaptée ou d'une microstructure particulière lorsque la phase gazeuse est introduite dans le conformateur.

Dans un autre mode de réalisation, l'installation comprend en outre, entre la source en phase gazeuse et avant l'outillage de conformation une zone de répartition du débit. Cette fonction de répartition peut être avantageusement incluse dans la zone intermédiaire. Cette fonction n'est utile que dans le cas où une pluralité d'orifices sont aménagés pour faire entrer la phase gazeuse réactive dans le conformateur. L'objectif de cette zone est d'obtenir une alimentation en gaz homogène de la préforme dans laquelle le dépôt est formé, idéalement en divisant le débit total en autant de fractions égales de débits que d'orifices présents.

Dans un procédé de consolidation de l'invention, la phase gazeuse peut être choisie parmi du méthane, du propane, du méthyltrichlorosilane, du silane, de l'éthylène, du trichlorure de bore, de l'ammoniac, étant entendu que ces espèces peuvent être prises seules, en mélange, ou en mélange avec d'autres gaz comme de l'hydrogène, de l'azote ou de l'argon.

Dans un mode de réalisation, un procédé de l'invention comprend l'introduction d'une première phase gazeuse permettant le dépôt d'une interphase de pyrocarbone ou de nitrure de bore sur les fibres constituant la préforme puis d'une deuxième phase gazeuse permettant le dépôt d'un carbure comme du carbure de silicium pour recouvrir le dépôt d'interphase.

Dans un tel mode de réalisation, la première phase gazeuse peut comprendre du trichlorure de bore, de l'ammoniac et l'hydrogène, voire est constituée de trichlorure de bore, d'ammoniac et d'hydrogène. La deuxième phase gazeuse peut comprendre du MTS et de l'hydrogène, voire est constituée de MTS et d'hydrogène.

Selon un autre de ses aspects, l'invention concerne encore un procédé de densification comprenant une première étape dans laquelle une préforme fibreuse est consolidée par le procédé de consolidation qui vient d'être décrit et au moyen d'un outillage de conformation tel que décrit ci-dessus, puis au moins une deuxième étape dans laquelle la préforme ainsi consolidée est placée dans un four de densification de l'art antérieur pour poursuivre sa densification.

D'une part, un tel procédé permet d'obtenir une densification plus rapide d'une préforme fibreuse, car la consolidation est initiée au moyen d'un outillage de conformation tel que décrit ci-dessus permettant un dépôt de meilleur rendement que les procédés de densification classiques. D'autre part, dans ce procédé, la densification de la préforme fibreuse est parachevée dans un four de densification classique, permettant d'assurer que les niveaux de densifications atteints pour la préforme fibreuse sont au moins aussi importants que ceux des préformes densifiées complètement par les procédés de l'art antérieur. Enfin, les défauts de type « pustules » éventuellement observés sur les pièces obtenues par les procédés de l'art antérieur sont évités.

### Brève description des dessins

[Fig. 1] La figure 1 représente un outillage de conformation dans un mode de réalisation d'un procédé selon l'invention.
[Fig. 2] La figure 2 représente un outillage de conformation dans un autre mode de réalisation d'un procédé selon l'invention.
[Fig. 3] La figure 3 représente une installation de conformation dans un mode de réalisation de l'invention.

### Description des modes de réalisation

Des outillages de conformation selon des modes de réalisation de procédés de l'invention vont maintenant être décrits en lien avec les figures, qui ne doivent pas être interprétées comme limitant l'invention.

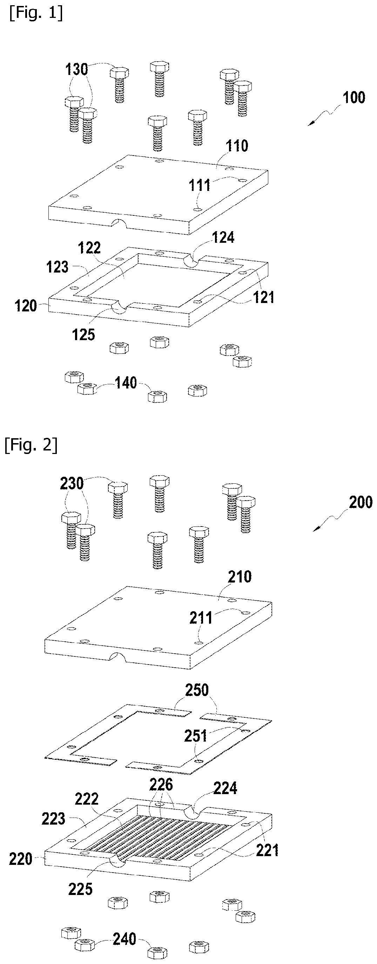

La figure 1 représente un outillage de conformation 100 selon un premier mode de réalisation.

Un tel outillage 100 est formé d'une première partie 110 et d'une deuxième partie 120. Ces deux parties 110, 120 peuvent être maintenues ensemble au moyen de vis 130 et d'écrous 140 traversant la première partie 110 par les orifices 111 et la deuxième partie par les orifices 121 ménagés à cet effet dans les zones de bord des première et deuxième parties.

La deuxième partie comprend une zone de conformation 122 et une zone de bord 123. La zone de conformation 122 présente, dans ce mode de réalisation, un décaissement par rapport à la zone de bord 123. La forme du décaissement de la zone de conformation 122 peut être choisie conforme à la forme souhaitée pour la pièce que l'on souhaite obtenir après consolidation.

Par « consolidation », on entend ici une densification partielle d'une préforme fibreuse à un niveau suffisant pour obtenir une préforme autoporteuse qui peut être placée ultérieurement dans un four de densification, sans outillage de conformation, pour finaliser sa densification.

Dans le mode de réalisation représenté en figure 1, la première partie 110 peut être identique à la deuxième partie 120.

Dans ce mode de réalisation, la mise en contact de la zone de bord 123 de la deuxième partie avec la zone de bord de la première partie définit un logement de conformation par l'association du décaissement ménagé entre la zone de conformation 122 et la zone de bord 123 de la deuxième partie, et celui de la zone de conformation de la première partie non visible sur le dessin. Dans le mode de réalisation représenté, la mise en contact des deux zones de bord permet également de former, dans les zones de bords, un orifice d'injection de gaz 125 et un orifice de sortie de gaz 124.

Dans un mode de réalisation non figuré, l'orifice d'injection de gaz 125 peut être entièrement ménagé dans la zone de bord de la première partie ou dans celle de la seconde partie.

Dans l'outillage de conformation 100 représenté, l'orifice d'injection de gaz 125 et l'orifice de sortie de gaz 124 sont formés par la réunion de deux ouvertures complémentaires ménagées dans les zones de bords des première et deuxième parties.

Dans un mode de réalisation non figuré, l'orifice de sortie de gaz peut être entièrement ménagé dans la zone de bord de la première partie ou dans celui de la deuxième partie.

Dans un outillage de conformation pour un procédé de l'invention, le passage de la phase gazeuse réactive au travers de la préforme fibreuse est forcée par la géométrie du conformateur. En effet, du fait de l'étanchéité du logement de conformation de l'outillage de conformation entre l'orifice d'injection de gaz et l'orifice de sortie de gaz, l'intégralité de la phase gazeuse passe dans la préforme fibreuse.

Dans le mode de réalisation représenté, la face externe de la première partie 110 est imperméable au gaz, et de même pour la face externe de la seconde partie.

Ainsi, la phase gazeuse ne peut entrer dans le logement de conformation ou le quitter que via l'orifice d'injection de gaz 125 et l'orifice de sortie de gaz 124.

L'imperméabilité aux gaz de la face externe de la première et de la deuxième partie peut être assurée par le matériau choisi pour la première et la deuxième partie.

Dans un mode de réalisation, la première et la deuxième partie peuvent être réalisées en graphite. Dans un autre mode de réalisation, la première et la deuxième partie peuvent être réalisées en matériau composite C/C, si nécessaire, rendu étanche par un dépôt de surface ou seal coat. Dans un autre mode de réalisation, la première partie 110 et la deuxième partie 120 peuvent être réalisées en matériau SiC fritté.

La figure 2 présente un outillage de conformation selon un autre mode de réalisation d'un procédé de l'invention.

Comme dans l'outillage représenté en figure 1, l'outillage présente une première partie 210 et une deuxième partie 220. La deuxième partie présente une zone de conformation 222 et une zone de bord 223. La première partie 210 est symétrique de la deuxième 220.

Des orifices 211 et 221 permettant le passage de vis 230 au travers de la première et de la deuxième partie sont présents. Ils permettent une fermeture de l'outillage de conformation au moyen de vis 230 et d'écrous 240.

L'outillage représenté comprend en outre des joints d'étanchéité 250 placés entre les zones de bords des première et deuxième parties 210, 220. Ces joints présentent également des orifices 251 permettant d'assurer le passage des vis 230.

Dans ce mode de réalisation, les joints assurent une étanchéité améliorée au logement de conformation. Comme décrit ci-dessus, l'étanchéité de la zone de conformation permet d'assurer un dépôt de la phase gazeuse uniquement dans la préforme fibreuse logée dans le logement de conformation.

Les joints d'étanchéité 250 peuvent avoir une largeur inférieure ou égale à la largeur de la zone de bord.

Dans le mode de réalisation représenté en figure 2, des reliefs de circulation de la phase gazeuse 226 sont présents dans la deuxième zone de conformation 222. Des reliefs de circulation de la phase gazeuse peuvent également être présents sur la première zone de conformation non visible sur le dessin.

Ces reliefs de circulation permettent à la phase gazeuse de circuler dans le logement de conformation lorsque la préforme fibreuse y est présente. Ainsi, la phase gazeuse peut pénétrer dans la préforme fibreuse tout au long de la préforme fibreuse, et ainsi, on évite toute obturation des pores de la préforme fibreuse en regard de l'orifice d'injection de gaz 225.

De tels reliefs de circulation 226 peuvent par exemple être gravés dans la zone de conformation 222. Bien entendu, la dimension des reliefs de circulation de la phase gazeuse 226 est choisie pour ne pas modifier substantiellement la forme du logement de conformation.

Dans un mode de réalisation, les rainures peuvent avoir une largeur n'excédant pas 3,0 mm, par exemple comprise entre 0,1 mm et 3,0 mm.

Dans un mode de réalisation éventuellement complémentaire, les rainures forment un angle compris entre 1° et 45°, de préférence compris entre 1° et 20°, voire entre 2° et 10° par rapport à la direction des fibres de la texture introduite dans la zone de conformation.

Un tel angle entre les rainures et les fibres de la préforme permet d'assurer que les fils de la texture ne puissent pas s'expanser dans la rainure ce qui diminue davantage encore le risque de formation de pustules.

Dans un mode de réalisation, la préforme est introduite dans la zone de conformation 222, de sorte que les fibres de la préforme soit substantiellement parallèles à la direction entre l'orifice d'injection de gaz 225 et l'orifice de sortie de gaz 224. Dans ce mode de réalisation, l'angle formé par les rainures est mesuré par rapport à la direction entre l'orifice d'injection de gaz 225 et l'orifice de sortie de gaz 224.

Par exemple, les reliefs de circulation de la phase gazeuse 226 peuvent être des rainures gravées dans la zone de conformation 222, parallèles à la direction entre l'orifice d'injection de gaz 225 et l'orifice de sortie de gaz 224 ou formant un angle avec cette direction comme précisé ci-dessus. De tels reliefs de circulation peuvent par exemple avoir une profondeur comprise entre 0,1 mm et 3,0 mm, un espacement entre deux rainures compris entre 2,0 mm et 5,0 mm, et une largeur comprise entre 0,1 mm à 3,0 mm.

Par exemple, les rainures peuvent avoir une longueur comprise entre 10 % et 100 % de la longueur de la zone de conformation.

Comme précisé ci-dessus, de tels reliefs de circulation de la phase gazeuse 226 sont particulièrement avantageux dans le cas où la phase gazeuse s'appauvrit rapidement lorsqu'elle traverse la préforme fibreuse ou qu'il existe un phénomène d'inhibition de dépôt. En effet, de tels reliefs de circulation permettent la pénétration de la phase gazeuse dans la préforme tout au long de la direction d'acheminement de la phase gazeuse, de l'orifice d'injection de gaz 225 à l'orifice de sortie de gaz 224, et ainsi, l'homogénéité de la densification dans la pièce obtenue après densification est meilleure qu'en l'absence des reliefs de circulation de la phase gazeuse 226.

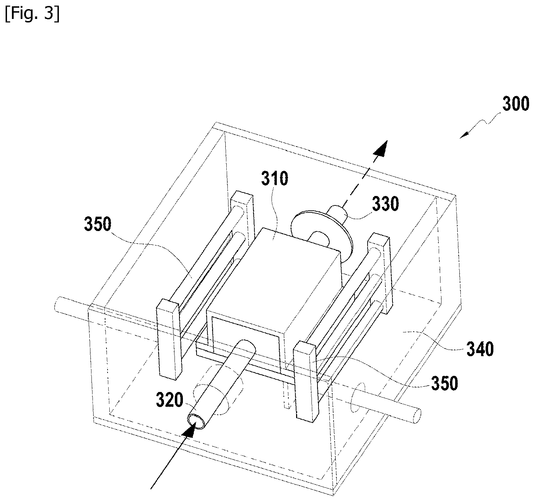

La figure 3 représente une installation selon l'invention permettant la consolidation de préformes fibreuses par dépôt chimique en phase vapeur.

Une telle installation 300 comprend un outillage de conformation 310, ou conformateur, selon un mode décrit ci-dessus.

L'installation 300 comprend en outre un moyen de chauffage de l'outillage de conformation 350. Tout mode de chauffage peut être utilisé sous réserve que celui-ci permette d'atteindre les températures de dépôt souhaitées. Par exemple, dans le mode de réalisation représenté, le chauffage est assuré par rayonnement et convection via des barreaux en graphite 350 disposés à proximité de l'outillage de conformation 310.

L'installation de densification 300 comprend en outre une source de phase gazeuse, non représentée et un conduit d'acheminement de la phase gazeuse 320 recevant le gaz depuis la source de phase gazeuse, le conduit d'acheminement 320 étant en communication avec l'orifice d'injection de gaz du conformateur.

Une installation de densification selon l'invention peut comprendre plusieurs sources de phase gazeuse. Par exemple, il est possible d'avoir deux sources de phase gazeuse distinctes, et l'utilisateur peut choisir laquelle des deux sources il souhaite connecter au conduit d'acheminement 320.

Un tel mode de réalisation permet de réaliser deux traitements successifs de la même préforme fibreuse, sans remplacer la source, mais simplement en reliant le conduit d'achement 320 à l'une ou à l'autre des sources. Ce mode de réalisation est particulièrement préféré quand une interphase est déposée sur la préforme fibreuse, avant sa densification.

Dans un mode de réalisation de l'invention, une même source de phase gazeuse permet l'alimentation de plusieurs installations de consolidation 300.

Dans le mode de réalisation représenté, l'installation de densification 300 comprend également un conduit de sortie de gaz 330 en communication avec l'orifice de sortie de gaz du conformateur.

L'installation représentée 300 présente de plus une enceinte isolante 340. Une telle enceinte permet d'optimiser la capacité de chauffe du système de chauffage 350 en diminuant la chaleur qui n'est pas transmise à l'outillage de conformation.

### Exemples

### Exemple 1 : Consolidation d'une préforme avec interphase

Une texture 3D à base de fibres de carbure de silicium HiNiC type S est introduite dans un outillage de conformation en graphite tel que décrit ci-dessus.

Le dépôt d'une interphase de BN est réalisé en connectant une source de phase gazeuse à l'orifice d'injection de gaz de l'outil de conformation. La source de phase gazeuse assure une alimentation en NH₃ et BCl₃, le rapport de débit entre NH₃ et BCl₃ étant compris entre 1 et 3 et NH₃ et BCl₃ étant dilués dans un gaz choisi parmi du dihydrogène, du diazote ou de l'argon, avantageusement du diazote. Le dépôt de BN est réalisé à une température comprise entre 700°C et 900°C.

La source de phase gazeuse assure un débit de NH₃ compris entre 100 à 1000 cm³ standard par minute, un débit de BCl₃ compris entre 100 et 500 cm³ standard par minute et un débit de gaz diluant compris entre 100 et 5000 cm³ standard par minute. Un dépôt de BN d'environ 0,3 à 1 µm d'épaisseur est ainsi obtenu.

La préforme fibreuse sur laquelle a été déposé le BN est ensuite densifiée par du SiC en connectant à l'orifice d'injection de gaz de l'outillage de conformation une source d'alimentation en méthyltrichlorosilane et en hydrogène.

La température de dépôt est comprise entre 900°C et 1050°C et la pression comprise entre 0,5 et 100 mbar.

Le rapport de débit entre l'hydrogène et le méthyltrichlorosilane est compris entre 3 et 15. Le débit de méthyltrichlorosilane est compris entre 20 et 200 cm³ standard par minute et le débit d'hydrogène entre 60 et 2000 cm³ standard par minute, et permet d'obtenir un dépôt de SiC sur le BN déposé auparavant d'environ 0,3 à 2 µm d'épaisseur.

Dans cet exemple, la durée de montée en température est de l'ordre de 1 à 2 heures. La durée nécessaire à la réalisation de l'interphase BN est de l'ordre d'une heure et la durée de réalisation du dépôt de carbure de silicium est de l'ordre de 2 à 3 heures.

La consolidation de la préforme fibreuse est donc obtenue dans un temps environ au moins dix fois inférieur au temps nécessaire pour un procédé de conformation de l'art antérieur.

### Exemple 2 : Consolidation d'une préforme avec interphase

Une texture 3D à base de fibres de carbure de silicium HiNiC type S est introduite dans un outillage de conformation en graphite tel que décrit ci-dessus.

Le dépôt d'une interphase de BN est réalisé en connectant une source de phase gazeuse à l'orifice d'injection de gaz de l'outil de conformation. La source de phase gazeuse assure une alimentation en borazine B₃N₃H₆, diluée dans un gaz choisi parmi du dihydrogène, du diazote ou de l'argon, avantageusement du diazote. Le dépôt de BN est réalisé à une température comprise entre 600°C et 900°C.

Pour faire un dépôt de BN d'environ 0,3 à 1 µm d'épaisseur, la source de phase gazeuse assure un débit de borazine compris entre 50 et 500 cm³ standard par minute et un débit de gaz diluant compris entre 200 et 2000 cm³ standard par minute.

La préforme fibreuse sur laquelle a été déposé le BN est ensuite consolidée par du SiC en connectant à l'orifice d'injection de gaz de l'outillage de conformation une source d'alimentation en silane SiH₄, en ethylène (C₂H₄) et en hydrogène.

La température de dépôt est comprise entre 700°C et 900°C et la pression comprise entre 0,5 et 10 mbar. Le rapport de débit entre le silane et l'éthylène est compris entre 0,5 et 3, avantageusement de 2.

Le débit de silane est compris entre 20 et 200 cm³ standard par minute, le débit d'éthylène est compris entre 20 et 150 cm³ standard par minute et le débit d'hydrogène est compris entre 20 et 500 cm³ standard par minute.

Un dépôt de SiC d'environ 0,3 à 2 µm d'épaisseur est ainsi obtenu sur le BN déposé auparavant.

Dans cet exemple, la durée de montée en température est de l'ordre de 1 à 2 heures. La durée nécessaire à la réalisation de l'interphase BN est de l'ordre d'une heure et la durée de réalisation du dépôt de carbure de silicium est de l'ordre de 2 à 3 heures.

La consolidation de la préforme fibreuse est donc obtenue dans un temps environ au moins dix fois inférieur au temps nécessaire pour un procédé de conformation de l'art antérieur.

### Exemple 3 : dépôt de pyrocarbone

Dans un outillage de conformation en graphite tel que décrit ci-dessus, une texture 3D à base de fibres de carbure de silicium HiNiC type S est introduite.

L'orifice d'injection de gaz de l'outillage de conformation est relié à une source de propane gazeux. La température de dépôt est comprise entre 850°C et 950°C, la pression est comprise entre 1 et 20 mbar.

Le débit de propane de la source est compris entre 50 et 500 cm³ standard par minute.

Un dépôt de pyrocarbone d'environ 0,3 à 1 µm d'épaisseur est obtenu.

Dans cet exemple, la durée de montée en température est de l'ordre de 1 à 2 heures. La durée nécessaire à la réalisation du dépôt de carbure de silicium est de l'ordre de 2 à 3 heures.

La consolidation de la préforme fibreuse est donc obtenue dans un temps environ au moins dix fois inférieur au temps nécessaire pour un procédé de conformation de l'art antérieur.

Il ressort des exemples ci-dessus que l'outillage de conformation permet une consolidation des préformes fibreuses bien plus rapide qu'avec les procédés de conformation de l'art antérieur.

## Revendications

1. Procédé de consolidation comprenant les étapes consistant en :
- placer une préforme fibreuse dans le logement de conformation d'un outillage de conformation (100),
- alimenter l'outillage de conformation avec une phase gazeuse pour obtenir un dépôt dans la préforme fibreuse,
l'outillage de conformation pour l'infiltration chimique en phase vapeur d'une préforme fibreuse comprenant une première partie (110) dont une face présente une première zone de conformation entourée d'une première zone de bord, et une deuxième partie (120), dont une face présente une deuxième zone de conformation (122) entourée d'une deuxième zone de bord (123), la première et la deuxième zone de conformation définissant, lors de la mise en contact de la première zone de bord avec la deuxième zone de bord, un logement de conformation de forme déterminée destiné à accueillir la préforme fibreuse,
l'outillage de conformation étant tel qu'au moins un orifice d'injection de gaz (125) est présent au moins partiellement dans la première ou dans la deuxième zone de bord et un orifice de sortie de gaz (124) est présent au moins partiellement dans la première ou dans la deuxième zone de bord, l'orifice d'injection de gaz et l'orifice de sortie de gaz mettant le logement de conformation en communication fluidique avec l'extérieur de l'outillage de conformation,
et tel que les faces externes de la première et de la deuxième partie sont imperméables aux gaz.

2. Procédé de consolidation selon la revendication 1, dans lequel l'utillage de conformation (100) comprend une première partie d'un orifice d'injection de gaz ménagé dans la première zone de bord, et une deuxième partie d'un orifice d'injection de gaz dans la deuxième zone de bord (123).

3. Procédé de consolidation selon la revendication 1 ou 2, dans lequel l'outillage de conformation (100)comprend une première partie d'un orifice de sortie de gaz ménagé dans la première zone de bord, et une deuxième partie d'un orifice de sortie de gaz dans la deuxième zone de bord (123).

4. Procédé de consolidation selon la revendication 1 à 3, dans lequel l'outillage de conformation (100) comprend en outre un joint d'étanchéité (250) entre les première et deuxième zones de bord (223).

5. Procédé de consolidation selon la revendication 1 à 4, dans lequel au moins l'une des zones de conformation de l'outillage de conformation (100) comprend un ou plusieurs reliefs de circulation de la phase gazeuse (226).

6. Installation de densification de préformes fibreuses (300) pour la mise en oeuvre d'un procédé selon l'une des revendications 1 à 5, comprenant ledit outillage de conformation (100), tel que défini dans la revendication 1, un moyen de chauffage de l'outillage de conformation (350) et une source de phase gazeuse connectée à l'orifice d'injection du gaz de l'outillage de conformation.

7. Installation de densification de préformes fibreuses (300) selon la revendication 6, comprenant en outre une zone de réaction des effluents connecté à l'orifice de sortie de gaz de l'outillage de conformation.

8. Installation de densification de préformes fibreuses (300) selon la revendication 6 ou 7, comprenant en outre une zone intermédiaire entre la source de phase gazeuse et l'outillage de conformation.

## Patentansprüche

1. Verfestigungsverfahren, umfassend die Schritte bestehend aus:
- Platzieren eines Faservorformlings in dem Formgebungsgehäuse eines Formgebungswerkzeugs (100),
- Versorgen des Formgebungswerkzeugs mit einer Gasphase, um eine Ablagerung in dem Faservorformling zu erhalten,
wobei das Formgebungswerkzeug für die chemische Dampfphaseninfiltration eines Faservorformlings einen ersten Teil (110), dessen eine Seite eine erste Formgebungszone aufweist, die von einer ersten Randzone umgeben ist, und einen zweiten Teil (120), dessen eine Seite eine zweite Formgebungszone (122) aufweist, die von einer zweiten Randzone (123) umgeben ist, umfasst, wobei die erste und die zweite Formgebungszone, wenn die erste Randzone mit der zweiten Randzone in Kontakt gebracht wird, ein Formgebungsgehäuse mit einer bestimmten Form definieren, das dazu bestimmt ist, den Faservorformling aufzunehmen,
wobei das Formgebungswerkzeug derart ist, dass zumindest eine Gaseinspritzöffnung (125) zumindest teilweise in der ersten oder in der zweiten Randzone vorhanden ist und eine Gasaustrittsöffnung (124) zumindest teilweise in der ersten oder in der zweiten Randzone vorhanden ist, wobei die Gaseinspritzöffnung und die Gasaustrittsöffnung das Formgebungsgehäuse in Fluidverbindung mit der Außenseite des Formgebungswerkzeugs bringen,
und derart, dass die Außenflächen des ersten und des zweiten Teils für Gase undurchlässig sind.

2. Verfestigungsverfahren nach Anspruch 1, wobei das Formgebungswerkzeug (100) einen ersten Teil einer Gaseinspritzöffnung, der in der ersten Randzone vorgesehen ist, und einen zweiten Teil einer Gaseinspritzöffnung in der zweiten Randzone (123) umfasst.

3. Verfestigungsverfahren nach Anspruch 1 oder 2, wobei das Formgebungswerkzeug (100) einen ersten Teil einer Gasaustrittsöffnung, der in der ersten Randzone vorgesehen ist, und einen zweiten Teil einer Gasaustrittsöffnung in der zweiten Randzone (123) umfasst.

4. Verfestigungsverfahren nach Anspruch 1 bis 3, wobei das Formgebungswerkzeug (100) ferner eine Dichtung (250) zwischen der ersten und der zweiten Randzone (223) umfasst.

5. Verfestigungsverfahren nach Anspruch 1 bis 4, wobei zumindest eine der Formgebungszonen des Formgebungswerkzeugs (100) ein oder mehrere Reliefs zur Zirkulation der Gasphase (226) umfasst.

6. Anlage zum Verdichten von Faservorformlingen (300) zur Durchführung eines Verfahrens nach einem der Ansprüche 1 bis 5, umfassend das Formgebungswerkzeug (100) wie in Anspruch 1 definiert, ein Mittel zum Erhitzen des Formgebungswerkzeugs (350) und eine Gasphasenquelle, die mit der Gaseinspritzöffnung des Formgebungswerkzeugs verbunden ist.

7. Anlage zum Verdichten von Faservorformlingen (300) nach Anspruch 6, ferner umfassend eine Abflussreaktionszone, die mit der Gasaustrittsöffnung des Formgebungswerkzeugs verbunden ist.

8. Anlage zum Verdichten von Faservorformlingen (300) nach Anspruch 6 oder 7, ferner umfassend eine Zwischenzone zwischen der Gasphasenquelle und dem Formgebungswerkzeug.

## Claims

1. A consolidation method comprising the steps consisting of:
- placing a fibrous preform in the shaping recess of a shaping tool (100),
- supplying the shaping tool with a gas phase to obtain a deposit in the fibrous preform,
the shaping tool for the vapor phase chemical infiltration of a fibrous preform comprising a first portion (110), one face of which has a first shaping zone surrounded by a first edge zone, and a second portion (120), one face of which has a second shaping zone (122) surrounded by a second edge zone (123), the first and the second shaping zone defining, when the first edge zone is brought into contact with the second edge zone, a shaping recess with a given shape intended to receive the fibrous preform,
**characterized in that** at least one gas injection port (125) is present at least partially in the first or in the second edge zone and a gas outlet port (124) is present at least partially in the first or in the second edge zone, the gas injection port and the gas outlet port placing the shaping recess in fluid communication with the outside of the shaping tool,
and **in that** the outer faces of the first and of the second portion are impermeable to gas.

2. The consolidation method according to claim 1, wherein the shaping tool (100) comprises a first portion of a gas injection port provided in the first edge zone, and a second portion of a gas injection port in the second edge zone (123).

3. The consolidation method according to claim 1 or 2, wherein the shaping tool (100) comprises a first portion of a gas outlet port provided in the first edge zone, and a second portion of a gas outlet port in the second edge zone (123).

4. The consolidation method according to claim 1 to 3, wherein the shaping tool (100) further comprises a gasket (250) between the first and the second edge zones (223).

5. The consolidation method according to claim 1 to 4, wherein at least one of the shaping zones of the shaping tool (100) comprises one or more gas phase flow relief(s) (226).

6. An installation for the densification of fibrous preforms (300) for the implementation of a method according to one of claims 1 to 5, comprising the shaping tool (100) according to the claim 1, a means for heating the shaping tool (350) and a gas phase source connected to the gas injection port of the shaping tool.

7. The installation for the densification of fibrous preforms (300) according to claim 6, further comprising an effluent reaction zone connected to the gas outlet port of the shaping tool.

8. The installation for the densification of fibrous preforms (300) according to claim 6 or 7, further comprising an intermediate zone between the gas phase source and the shaping tool.
